(19) Europäisches Patentamt / European Patent Office / Office européen des brevets

(11) **EP 2 721 734 B1**

(12) **FASCICULE DE BREVET EUROPEEN**

(45) Date de publication et mention de la délivrance du brevet:
**21.03.2018 Bulletin 2018/12**

(21) Numéro de dépôt: **12728523.7**

(22) Date de dépôt: **18.06.2012**

(51) Int Cl.:
*H03G 3/30* (2006.01)        *H03G 7/00* (2006.01)

(86) Numéro de dépôt international:
**PCT/EP2012/061602**

(87) Numéro de publication internationale:
**WO 2012/172109 (20.12.2012 Gazette 2012/51)**

(54) **PROCÉDÉ DE NORMALISATION DE LA PUISSANCE D'UN SIGNAL SONORE ET DISPOSITIF DE TRAITEMENT ASSOCIÉ**

VERFAHREN ZUR NORMALISIERUNG DER LEISTUNG EINES TONSIGNALS UND ZUGEHÖRIGE VERARBEITUNGSVORRICHTUNG

METHOD FOR NORMALIZING THE POWER OF A SOUND SIGNAL, AND ASSOCIATED PROCESSING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.06.2011 FR 1101868**

(43) Date de publication de la demande:
**23.04.2014 Bulletin 2014/17**

(73) Titulaire: **Arkamys**
**75017 Paris (FR)**

(72) Inventeurs:
• **AMADU, Frédéric**
  **F-77500 Chelles (FR)**
• **ESNAULT, Thomas**
  **F-75019 Paris (FR)**
• **FENIERES, Alexandre**
  **F-75010 Paris (FR)**

(74) Mandataire: **Ipside**
**29, rue de Lisbonne**
**75008 Paris (FR)**

(56) Documents cités:
**GB-A- 2 147 165      US-A- 5 038 310**
**US-B1- 7 848 531**

• VICKERS ET AL: "The Loudness War: Background, Speculation, and Recommendations", AES CONVENTION 129; NOVEMBER 2010, AES, 60 EAST 42ND STREET, ROOM 2520 NEW YORK 10165-2520, USA, 4 novembre 2010 (2010-11-04), XP040567146,
• WOLTERS MARTIN ET AL: "Loudness Normalization in the Age of Portable Media Players", AES CONVENTION 128; MAY 2010, AES, 60 EAST 42ND STREET, ROOM 2520 NEW YORK 10165-2520, USA, 1 mai 2010 (2010-05-01), XP040509427,

## Description

### DOMAINE TECHNIQUE DE L'INVENTION

L'invention concerne un procédé de normalisation du niveau d'un signal sonore ainsi que le dispositif de traitement associé.

L'invention trouve une application particulièrement avantageuse dans le domaine des appareils de restitution sonore, tels que les télévisions numériques, les autoradios, ou les lecteurs de type MP3.

### ETAT DE LA TECHNIQUE

Les signaux sonores à diffuser par ces appareils de restitution sonore présentent des variations de puissance moyenne, soit parce qu'ils proviennent de sources différentes (canaux radio différents, pistes de lectures différentes) présentant chacune des qualités différentes, soit parce que la source elle-même émet un signal dont la qualité varie en fonction du temps.

En conséquence, lorsque le signal est diffusé par le dispositif de restitution et amplifié suivant un gain statique, l'auditeur perçoit un son ayant un volume variable, ce qui est désagréable à l'écoute.

Pour résoudre ce problème, les procédés de l'art antérieur consistent à ajuster la puissance du signal de sorte que la puissance moyenne du son diffusé soit constante. A cet effet, un gain variable est appliqué au signal sonore tel qu'il est émis par la source, dit signal sonore original.

On connaît dans l'état de la technique le brevet américain N° US 5 038 310 qui décrit un circuit électronique de compression et/ou d'expansion d'amplitude. On connaît également le brevet américain N° US 7 848 531 B1 décrivant un procédé et un dispositif de mise en correspondance du volume sonore avec la gamme dynamique d'un signal sonore. En outre, on connaît la demande de brevet britannique N° GB 2 147 165 A qui décrit un dispositif de contrôle de la gamme dynamique d'un signal sonore.

Toutefois, ces procédés de l'art antérieur ne permettent pas de respecter la dynamique originale du signal sonore de sorte qu'aucun relief sonore n'est perçu par l'auditeur dans le son finalement diffusé.

### OBJET DE L'INVENTION

L'invention vise à remédier à cet inconvénient et concerne à cet effet un procédé de normalisation de la puissance d'un signal électrique, dit signal sonore original, selon la revendication indépendante 1.

Ainsi le son diffusé est normalisé tout en conservant le relief sonore du signal sonore original.

Le procédé objet de l'invention peut être mis en oeuvre selon les modes de réalisation avantageux exposés ci-après lesquels peuvent être considérés individuellement ou selon toute combinaison techniquement opérante dans le cadre défini par les revendications.

Avantageusement, pour obtenir le signal de gain lissé, le procédé objet de l'invention comporte l'étape d'intégrer le signal de gain sur un front montant sur une durée plus importante que la durée sur laquelle le signal de gain est intégré sur un front descendant.

Avantageusement, le procédé objet de l'invention comporte les étapes consistant à :

- détecter lorsque la puissance du signal sonore original est inférieure à une valeur seuil pendant une durée seuil, dite durée d'arrêt,
- diminuer progressivement le signal de gain lissé à partir de la fin de la durée d'arrêt jusqu'à la valeur de gain unité,
- de manière à créer un effet d'arrêt naturel progressif du signal sonore original.

Avantageusement, le signal de gain lissé diminue suivant une fonction de type exponentielle décroissante.

Le procédé objet de l'invention comporte selon un mode de réalisation avantageux une étape consistant à limiter les valeurs du signal de gain supérieures à un seuil, dit seuil limite supérieur, à ce seuil limite supérieur.

Selon une mise en oeuvre avantageuse du procédé objet de l'invention, celui-ci comporte une étape consistant à limiter les valeurs du signal de gain inférieures à un seuil, dit seuil limite inférieur, à ce seuil limite inférieur.

Avantageusement, la valeur seuil est modifiable par un utilisateur.

Selon un mode de réalisation du procédé objet de l'invention, le retard appliqué au signal sonore original est compris entre 2 et 3 millisecondes.

L'invention concerne en outre un dispositif de traitement comportant des moyens pour la mise en oeuvre du procédé objet de l'invention selon l'un quelconque de ses modes de mise en oeuvre.

### BREVE DESCRIPTION DES FIGURES

L'invention est exposée ci-après selon ses modes de réalisation préférés, nullement limitatifs, et en référence aux figures 1 à 3, lesquelles montrent :

Figure 1 : une représentation schématique du dispositif de traitement du son selon l'invention sous forme de blocs fonctionnels ;

Figure 2 : une représentation graphique en fonction du temps des signaux obtenus en sortie des blocs fonctionnels du dispositif de la Figure 1 au cours des étapes conduisant à la limitation en puissance du signal sonore original ;

Figure 3 : des représentations graphiques en fonction du temps des signaux des blocs fonctionnels du dispositif de la Figure 1 au cours des étapes conduisant à une réduction progressive du niveau du signal sonore original.

Les éléments identiques, similaires, ou analogues, conservent la même référence d'une figure à l'autre.

**DESCRIPTION D'EXEMPLES DE REALISATION DE L'INVENTION**

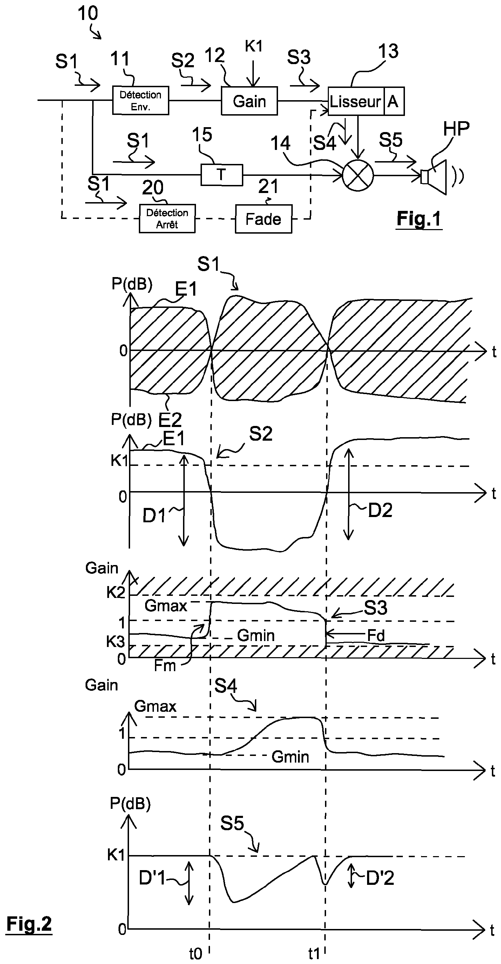

La Figure 1 montre un dispositif 10 de traitement selon l'invention apte à normaliser la puissance d'un signal sonore original. Ce dispositif 10 de traitement peut être intégré par exemple à l'intérieur d'une télévision numérique, d'un autoradio, ou d'un lecteur de type MP3.

Ce dispositif 10 comporte un module 11 de détection d'enveloppe, un module 12 de calcul de gain et un module 13 de lissage de gain. Un module 14 de combinaison et un module 15 de retard permettent d'appliquer le signal de gain lissé obtenu en sortie du module 13 sur le signal sonore original retardé d'un retard T.

La Figure 2 montre l'évolution en fonction du temps de la puissance des signaux S1, S2, S5 correspondant respectivement au signal sonore original, au signal obtenu en sortie du module 11, et au signal obtenu en sortie du module 14. La Figure 2 montre également l'évolution dans le temps de la valeur en gain des signaux S3 et S4 obtenus respectivement en sortie des modules 12 et 13.

Plus précisément, le module 11 détecte l'enveloppe du signal S1 sonore original appliqué sur une de ses entrées et génère le signal S2 d'enveloppe. Le module 11 détecte de préférence uniquement une partie E1 de l'enveloppe du signal S1, l'autre partie E2 étant opposée par rapport à E1.

Le module 12 compare la valeur du gain du signal S2 d'enveloppe avec une valeur seuil K1. De préférence, la valeur seuil K1 comprise entre -6 et -12 dB est modifiable par l'utilisateur. Le module 12 calcule alors un signal S3 de gain en fonction de cette comparaison. Le signal S3 de gain présente des valeurs telles que lorsque le signal S3 de gain est appliqué au signal sonore original S1, le signal obtenu présente sensiblement une puissance égale à la valeur seuil K1 sélectionnée par l'utilisateur.

De préférence, le module 12 limite les valeurs du signal S3 de gain supérieures à un seuil K2, dit seuil limite supérieur, à ce seuil limite supérieur. De préférence, le module 12 limite également les valeurs du signal S3 de gain inférieures à un seuil K3, dit seuil limite inférieur, à ce seuil limite inférieur. Dans un exemple de mise en oeuvre, le seuil limite supérieur K2 et le seuil limite inférieur K3 valent respectivement plus ou moins 45dB.

Le module 13 assure ensuite un lissage du signal de gain S3. A cet effet, le module 13 intègre le signal S3 de gain sur un front montant Fm sur une durée plus importante que la durée sur laquelle le signal S3 de gain est intégré sur un front descendant Fd. Un front montant Fm est observable lorsque le signal S3 de gain passe d'une valeur inférieure à un gain unité à une valeur supérieure au gain unité. Inversement, un front descendant Fd est observable lorsque le signal S3 de gain passe d'une valeur supérieure au gain unité à une valeur inférieure au gain unité.

Plus précisément, le signal de gain S3 et le signal de gain lissé S4 ayant été préalablement échantillonnés, chaque échantillon présente un rang donné correspondant à l'instant auquel il a été obtenu.

Dans ces conditions, la valeur de gain lissée de rang n (liss(n)) obtenue en sortie du module 13 de lissage est fonction de la valeur de gain lissée de rang n-1 (liss(n-1)) et de la soustraction entre la valeur de gain courante de rang n (cour(n)) et la valeur de gain lissée de rang n-1 (liss(n-1)) pondérée par une valeur de lissage A comprise entre 0 et 1.

Selon un exemple de réalisation, la valeur de gain lissée de rang n (liss(n)) obtenue en sortie du module 13 vaut :

$$\text{Liss(n)=liss(n-1)+[(cour(n)-liss(n-1))xA]}$$

- la valeur de lissage A étant proche de 1 si la valeur de gain courante (cour(n)) est inférieure à la valeur de gain lissée précédente (liss(n-1)) sur un front descendant du signal. Selon un exemple de mise en oeuvre, la valeur A de lissage est comprise entre 0,90 et 0.98.

- la valeur de lissage A étant proche de 0 si la valeur de gain courante (cour(n)) est supérieure à la valeur de gain lissée précédente (liss(n-1)) sur un front montant du signal. Selon un exemple de mise en oeuvre, la valeur A de lissage est comprise alors entre 0,00001 et 0,00002.

La Figure 2 représente le signal S4 de gain lissé obtenu en sortie du module 13. Ainsi, pour un front montant Fm du gain non lissé (signal S3), le gain augmente lentement vers la valeur cible, Gmax, à atteindre. En revanche, pour un front descendant Fd du gain non lissé, le gain descend rapidement vers la valeur cible, Gmin, à atteindre.

Par ailleurs, le module 15 retarde le signal S1 sonore original d'un retard T. Ce retard T correspond au temps nécessaire au dispositif 10 objet de l'invention, pour élaborer le signal de gain lissé S4. Le retard T est par exemple compris entre 2 et 3 millisecondes.

Le module 14 de combinaison permet d'appliquer le signal de gain lissé sur le signal S1 sonore original retardé de manière à obtenir un signal S5 sonore normalisé ayant une puissance proche de la valeur seuil K1.

Ainsi, les variations D1, D2 de niveau sonore qui existaient dans le signal S1 sonore original sont conservées dans le signal sonore normalisé S5 (voir les variations correspondantes D1' et D2'), tandis que la puissance du signal normalisé S5 ne dépasse pas la valeur limite K1 de puissance seuil.

Autrement dit, l'invention permet de conserver le relief sonore du signal sonore original S1.

Le procédé objet de l'invention permet également de diminuer progressivement la puissance du signal sonore original S1 lorsque la puissance du signal sonore original est inférieure à un seuil pendant une durée seuil.

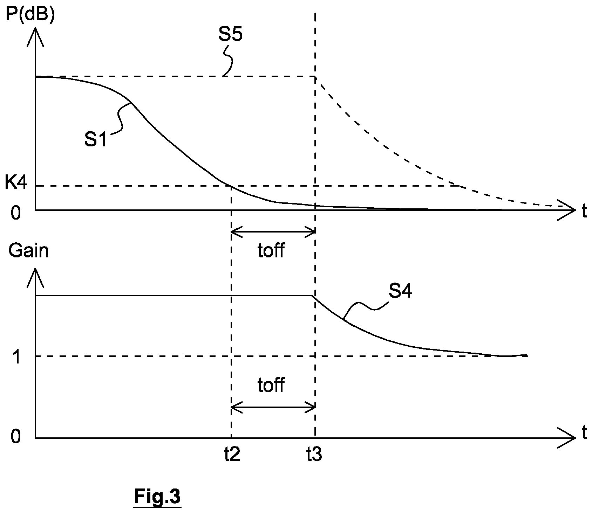

A cet effet, un module 20 détecte lorsque la puissance du signal S1 sonore original est inférieure à une valeur seuil K4 pendant une durée Toff, dite durée d'arrêt, qui s'étend entre les instants t2 et t3, Figure 3. Selon un exemple de réalisation, la valeur seuil K4 est de l'ordre de -60dB ; tandis que la durée d'arrêt Toff est de l'ordre de 2000 millisecondes.

Un module 21 diminue alors progressivement le signal de gain lissé S4 lequel est proche de son niveau maximum, à partir de la fin de la durée d'arrêt Toff à l'instant t3, jusqu'à une valeur de gain égale à 1. Cela a pour effet de diminuer progressivement la puissance du signal S5 à diffuser qui suit ainsi l'évolution du signal S1 sonore original. Suivant une mise en oeuvre, le gain du signal S4 diminue suivant une fonction de type exponentielle décroissante.

L'invention permet ainsi de créer un effet d'arrêt naturel progressif du signal sonore original (effet sonore dit « fade » en anglais) que l'on rencontre notamment à la fin des morceaux de musique.

L'invention est avantageusement mise en oeuvre avec une pluralité de canaux (chaînes de TV, stations de radio, ...) associés chacun à au moins un signal sonore original.

Dans ce cas, le gain minimal est enregistré lors d'un changement de canal. Ainsi, si à l'instant ti, un utilisateur sélectionne un premier canal et qu'à l'instant tj, l'utilisateur change de canal, le gain minimal calculé sur la période entre ti et tj pour le premier canal est stocké dans une mémoire. Ce gain est rechargé lorsque ce même premier canal est à nouveau sélectionné par l'utilisateur. Ainsi, le gain minimal à appliquer est stocké pour chaque canal.

Le gain global appliqué sur le ou les signaux d'un canal est alors égal à la somme d'un gain statique correspondant de préférence à la valeur de gain minimum du canal préalablement enregistré et d'un gain dynamique obtenus selon le procédé exposé ci-avant. La valeur de gain minimum est régulièrement mise à jour si elle correspond à la valeur de gain minimum de la session précédente, ou figée après avoir été calculée lors d'une première session. Le terme « session » désigne ici la sélection d'un canal par l'utilisateur sur une période de temps donnée qui se termine lorsque l'utilisateur change de canal.

Plus précisément, dans ce cas, le signal de gain dynamique est calculé à partir de la comparaison entre le signal S2 duquel est préalablement soustrait une puissance correspondant au gain statique et la valeur seuil K1. Comme précédemment exposé, ce signal de gain dynamique est lissé pour ensuite être appliqué sur le signal sonore original retardé de manière à obtenir un signal sonore normalisé ayant une puissance proche de la valeur seuil K1.

Ainsi, les variations de gain sont moindres et la dynamique du signal sonore original est complètement respectée.

## Revendications

1. Procédé de normalisation de la puissance d'un signal électrique, dit signal (S1) sonore original, une pluralité de canaux étant associés chacun à un signal sonore original, ledit procédé comportant les étapes consistant à :

   - détecter l'enveloppe du signal (S1) sonore original de manière à obtenir un signal d'enveloppe (S2),
   - comparer la valeur du gain du signal d'enveloppe (S2) avec une valeur seuil (K1),
   - calculer un signal de gain (S3) en fonction de cette comparaison,
   - retarder le signal (S1) sonore original d'un retard (T) de manière à obtenir un signal sonore original retardé,
   - lisser le signal de gain (S3) pour obtenir un signal de gain lissé (S4), le signal de gain (S3) et le signal de gain lissé (S4) étant échantillonnés,

     - la valeur de gain lissé de rang n (liss(n)) étant égale à la somme de la valeur de gain lissée de rang n-1 (liss(n-1)) et de la soustraction entre la valeur de gain courante de rang n (cour(n)) et la valeur de gain lissée de rang n-1, cette soustraction étant pondérée par une valeur de lissage (A),
     - ladite valeur de lissage (A) étant comprise entre 0,90 et 0,98 si la valeur de gain courante (cour(n)) est inférieure à la valeur de gain lissée précédente (liss(n-1)),
     - ladite valeur de lissage (A) étant comprise entre 0,00001 et 0,00002 si la valeur de gain courante est supérieure à la valeur de gain lissée précédente.

     - enregistrer la valeur minimale du signal de gain lissé (Gmin) appliquée au signal sonore original retardé du canal en cours lors d'un changement de canal de manière à pouvoir le recharger ultérieurement,
     - la valeur du signal de gain appliqué sur le signal (S1) sonore original retardé du canal étant égale, lors d'une nouvelle sélection du canal, à la somme de la valeur minimale du signal de gain préalablement enregistrée, dite valeur statique, et d'une valeur de gain dynamique,

- la valeur du signal de gain dynamique étant calculée à partir de la comparaison entre la valeur en puissance du signal d'enveloppe (S2) du canal diminuée de la puissance correspondant au gain statique et de la valeur seuil (K1), et

- appliquer le signal (S4) de gain lissé sur le signal (S1) sonore original retardé de manière à obtenir un signal (S5) sonore normalisé ayant une puissance proche de la valeur seuil (K1).

2.  Procédé selon la revendication 1, **caractérisé en ce que** pour obtenir le signal de gain lissé, il comporte l'étape d'intégrer le signal de gain (S3) sur un front montant (Fm) sur une durée plus importante que la durée sur laquelle le signal de gain (S3) est intégré sur un front descendant (Fd).

3.  Procédé selon l'une des revendications 1 ou 2, **caractérisé en ce qu'**il comporte les étapes suivantes :

- détecter lorsque la puissance du signal sonore original (S1) est inférieure à une valeur seuil (K4) pendant une durée seuil (Toff), dite durée d'arrêt,

- diminuer progressivement le signal de gain lissé (S4) à partir de la fin de la durée d'arrêt (TA) jusqu'à la valeur de gain unité,

- de manière à créer un effet d'arrêt naturel progressif du signal sonore original (S1).

4.  Procédé selon la revendication 3, **caractérisé en ce que** le signal de gain lissé (S4) diminue suivant une fonction de type exponentielle décroissante.

5.  Procédé selon l'une des revendications 1 à 4, **caractérisé en ce qu'**il comporte une étape consistant à limiter les valeurs du signal de gain supérieures à un seuil, dit seuil limite supérieur, à ce seuil limite supérieur.

6.  Procédé selon l'une des revendications 1 à 5, **caractérisé en ce qu'**il comporte une étape consistant à limiter les valeurs du signal de gain inférieures à un seuil, dit seuil limite inférieur, à ce seuil limite inférieur.

7.  Procédé selon l'une des revendications 1 à 6, **caractérisé en ce que** la valeur seuil (K1) est modifiable par un utilisateur.

8.  Procédé selon l'une des revendications 1 à 7, **caractérisé en ce que** le retard (T) appliqué au signal sonore original (S1) est compris entre 2 et 3 millisecondes.

9.  Dispositif de traitement **caractérisé en ce qu'**il comporte des moyens pour la mise en oeuvre du procédé selon l'une des revendications 1 à 8.

**Patentansprüche**

1.  Verfahren zur Normalisierung der Leistung eines elektrischen Signals, das ursprüngliches Tonsignal (S1) genannt wird, wobei mehrere Kanäle jeweils mit einem ursprünglichen Tonsignal in Verbindung stehen, das Verfahren umfassend die Schritte, die aus Folgendem bestehen:

- Erkennen der Hüllkurve des ursprünglichen Tonsignals (S1), um ein Hüllkurvensignal (S2) zu erhalten,

- Vergleichen des Werts der Verstärkung des Hüllkurvensignals (S2) mit einem Schwellenwert (K1),

- Berechnen eines Verstärkungssignals (S3) in Abhängigkeit von diesem Vergleich,

- Verzögern des ursprünglichen Tonsignals (S1) um eine Verzögerung (T), um ein verzögertes ursprüngliches Tonsignal zu erhalten,

- Glätten des Verstärkungssignals (S3), um ein geglättetes Verstärkungssignal (S4) zu erhalten, wobei das Verstärkungssignal (S3) und das geglättete Verstärkungssignal (S4) abgetastet werden,

- wobei der geglätteten Verstärkungswert von Rang n (glatt(n)) gleich der Summe des geglätteten Verstärkungswerts von Rang n-1 (glatt(n-1)) und der Subtraktion zwischen dem aktuellen Verstärkungswert von Rang n (akt(n)) und dem geglätteten Verstärkungswert von Rang n-1 ist, wobei diese Subtraktion mit einem Glättungswert (A) gewichtet wird,

- wobei der Glättungswert (A) zwischen 0,90 und 0,098 liegt, wenn der aktuelle Verstärkungswert (akt(n)) kleiner als der vorige geglättete Verstärkungswert (glatt(n-1)) ist,

- wobei der Glättungswert (A) zwischen 0,00001 und 0,00002 liegt, wenn der aktuelle Verstärkungswert größer als der vorige geglättete Verstärkungswert ist,

- Speichern des Mindestwerts des geglätteten Verstärkungssignals (Gmin), der auf das verzögerte ursprüngliche Tonsignal des laufenden Kanals angewandt wird, bei einem Kanalwechsel, um ihn später erneut laden zu können,

- wobei der Wert des Verstärkungssignals, das auf das verzögerte ursprüngliche Tonsignal (S1) des Kanals angewandt wird, bei einer erneuten Kanalauswahl gleich der Summe des Mindestwerts des zuvor gespeicherten Verstärkungssignals, statischer Wert genannt, und eines dynamischen Verstärkungswerts ist,

- wobei der Wert des dynamischen Verstärkungssignals anhand des Vergleichs zwischen dem Leistungswert des Hüllkurvensignals (S2) des Kanals, der um die Leistung, die der statischen Verstärkung entspricht, verringert wurde, und dem Schwellenwert (K1) berechnet wird, und

- Anwenden des geglätteten Verstärkungssignals (S4) auf das verzögerte ursprüngliche Tonsignal (S1), um ein normalisiertes Tonsignal (S5) zu erhalten, das eine Leistung nahe des Schwellenwerts (K1) aufweist.

2. Verfahren nach Anspruch 1, **dadurch gekennzeichnet, dass** es den Schritt des Integrierens des Verstärkungssignals (S3) auf einer steigenden Flanke (Fm) über eine Dauer, die größer als die Dauer ist, über welche das Verstärkungssignal (S3) auf der fallenden Flanke (Fd) integriert wird, umfasst, um das geglättete Verstärkungssignal zu erhalten.

3. Verfahren nach einem der Ansprüche 1 oder 2, **dadurch gekennzeichnet, dass** es die folgenden Schritte umfasst:

- Erkennen, wenn die Leistung des ursprünglichen Tonsignals (S1) während einer Schwellendauer (Toff), Unterbrechungszeit genannt, unter einem Schwellenwert (K4) liegt,
- schrittweises Verringern des geglätteten Verstärkungssignals (S4) ab dem Ende der Unterbrechungszeit (TA) bis zu dem Einheits-Verstärkungswert,
- um einen Effekt einer schrittweisen natürlichen Unterbrechung des ursprünglichen Tonsignals (S1) zu erzeugen.

4. Verfahren nach Anspruch 3, **dadurch gekennzeichnet, dass** das geglättete Verstärkungssignal (S4) entsprechend einer Funktion exponentieller Abnahme abnimmt.

5. Verfahren nach einem der Ansprüche 1 bis 4, **dadurch gekennzeichnet, dass** es einen Schritt umfasst, der darin besteht, die Werte des Verstärkungssignals, die größer als eine Schwelle sind, die obere Grenzschwelle genannt wird, auf diese obere Grenzschwelle zu begrenzen.

6. Verfahren nach einem der Ansprüche 1 bis 5, **dadurch gekennzeichnet, dass** es einen Schritt umfasst, der darin besteht, die Werte des Verstärkungssignals, die kleiner als eine Schwelle sind, die untere Grenzschwelle genannt wird, auf diese untere Grenzschwelle zu begrenzen.

7. Verfahren nach einem der Ansprüche 1 bis 6, **dadurch gekennzeichnet, dass** der Schwellenwert (K1) von einem Benutzer änderbar ist.

8. Verfahren nach einem der Ansprüche 1 bis 7, **dadurch gekennzeichnet, dass** die Verzögerung (T), die auf das ursprüngliche Tonsignal (S1) angewandt wird, zwischen 2 und 3 Millisekunden beträgt.

9. Verarbeitungsvorrichtung, **dadurch gekennzeichnet, dass** sie Mittel zur Umsetzung des Verfahrens nach einem der Ansprüche 1 bis 8 umfasst.

**Claims**

1. Method for normalizing the power of an electrical signal, termed original acoustic signal (S1), a plurality of channels each being associated with an original acoustic signal, said method including the steps consisting in:

- detecting the envelope of the original acoustic signal (S1) so as to obtain an envelope signal (S2),
- comparing the value of the gain of the envelope signal (S2) with a threshold value (K1),
- calculating a gain signal (S3) on the basis of this comparison,
- delaying the original acoustic signal (S1) by a delay (T) so as to obtain a delayed original acoustic signal,
- smoothing the gain signal (S3) in order to obtain a smoothed gain signal (S4), the gain signal (S3) and the smoothed gain signal (S4) being sampled,

- the smoothed gain value of rank n (smooth(n)) being equal to the sum of the smoothed gain value of rank n-1 (smooth(n-1)) and the subtraction between the current gain value of rank n (curr(n)) and the smoothed gain value of rank n-1, this subtraction being weighted by a smoothing value (A),
- said smoothing value (A) being between 0.90 and 0.98 if the current gain value (curr(n)) is lower than the previous smoothed gain value (smooth(n-1)),
- said smoothing value (A) being between 0.00001 and 0.00002 if the current gain value is higher than the previous smoothed gain value,

- recording the minimum value of the smoothed gain signal (Gmin), which value is applied to the delayed original acoustic signal of the current channel upon a change of channel so as to subsequently be able to reload it,
- the value of the gain signal applied to the delayed original acoustic signal (S1) of the channel being equal, upon a new selection of the channel, to the sum of the minimum value, recorded beforehand and termed static value, of the gain signal and a dynamic gain value,
- the value of the dynamic gain signal being calculated on the basis of the comparison between the power value of the envelope signal (S2) of the channel minus the power corresponding to the static gain and the threshold value (K1), and
- applying the smoothed gain signal (S4) to the delayed original acoustic signal (S1) so as to obtain a normalized acoustic signal (S5) having a power close to the threshold value (K1).

2. Method according to Claim 1, **characterized in that**, in order to obtain the smoothed gain signal, it includes the step of integrating the gain signal (S3) over a rising edge (Fm) over a duration greater than the duration over which the gain signal (S3) is integrated over a falling edge (Fd).

3. Method according to either of Claims 1 and 2, **characterized in that** it includes the following steps:

- detecting when the power of the original acoustic signal (S1) is less than a threshold value (K4) for a threshold duration (Toff), termed stoppage duration,
- gradually reducing the smoothed gain signal (S4) starting from the end of the stoppage duration (TA) as far as the unity gain value,
- so as to create an effect of gradual natural stoppage of the original acoustic signal (S1).

4. Method according to Claim 3, **characterized in that** the smoothed gain signal (S4) reduces in line with a decreasing exponential function.

5. Method according to one of Claims 1 to 4, **characterized in that** it includes a step consisting in limiting the values of the gain signal that are higher than a threshold, termed upper limit threshold, to this upper limit threshold.

6. Method according to one of Claims 1 to 5, **characterized in that** it includes a step consisting in limiting the values of the gain signal that are lower than a threshold, termed lower limit threshold, to this lower limit threshold.

7. Method according to one of Claims 1 to 6, **characterized in that** the threshold value (K1) is able to be modified by a user.

8. Method according to one of Claims 1 to 7, **charac-**

**terized in that** the delay (T) applied to the original acoustic signal (S1) is of between 2 and 3 milliseconds.

9. Processing device, **characterized in that** it includes means for implementing the method according to one of Claims 1 to 8.

**Fig.1**

**Fig.2**

**Fig.3**

## RÉFÉRENCES CITÉES DANS LA DESCRIPTION

**Documents brevets cités dans la description**

- US 5038310 A
- US 7848531 B1
- GB 2147165 A